Europäisches Patentamt

European Patent Office

Office européen des brevets

(11) Publication number: **0 518 377 A2**

## EUROPEAN PATENT APPLICATION

(21) Application number: **92109956.0**

(22) Date of filing: **12.06.92**

(51) Int. Cl.5: **H01L 21/20, H01L 21/285**

(30) Priority: **14.06.91 JP 143291/91**
**14.06.91 JP 143292/91**
**14.06.91 JP 143294/91**

(43) Date of publication of application:
**16.12.92 Bulletin 92/51**

(84) Designated Contracting States:
**DE FR GB**

(71) Applicant: **CANON KABUSHIKI KAISHA**
**30-2, 3-chome, Shimomaruko, Ohta-ku**
**Tokyo(JP)**

(72) Inventor: **Aiba, Toshiaki, c/o Canon Kabushiki**
**Kaisha**
**30-2, 3-chome, Shimomaruko**
**Ohta-ku, Tokyo 146(JP)**
Inventor: **Morishita, Masakazu, c/o Canon**
**Kabushiki Kaisha**
**30-2, 3-chome, Shimomaruko**
**Ohta-ku, Tokyo 146(JP)**

(74) Representative: **Bühling, Gerhard, Dipl.-Chem.**
**et al**
**Patentanwaltsbüro Tiedtke-Bühling-Kinne &**
**Partner, Bavariaring 4**
**W-8000 München 2(DE)**

(54) Method for forming a seed and a semiconductor film using said seed.

(57) A seed is formed in a manner that a crystalline film is formed on an underlayer material, and then partly made amorphous by ion implanting impurities into the crystalline film, with a crystalline portion left behind in part thereof. After forming a step configuration on the underlayer material, the crystalline film is formed, and ions are implanted over its entire surface of the crystalline film.

FIG. 1D

105

104 SEED

EP 0 518 377 A2

BACKGROUND OF THE INVENTION

Field of the Invention

The present invention relates to a method for forming a seed which serves as a starting region in recrystallization with the solid phase growth by ion implantation, and a method for forming a semiconductor film using the seed.

Related Background Art

Conventionally, in forming a seed on underlayer material, one of the forming methods is typically adopted in which after crystalline film is formed on a substrate or underlayer material of an insulating material, a resist is patterned on a part of the crystal, and then impurities are ion implanted over the entire surface thereof.

Also, a method not using the resist is adopted in which after amorphous film is formed on a substrate or underlayer material of an insulating material, a laser is applied onto a part of the amorphous film to anneal and thereby crystallize that part to form the seed.

However, in such a conventional method for forming the seed, it is difficult to make the size of the seed minute. When the resist was used, there was a problem of causing contamination on the film surface due to sputtering of the resist at the ion implantation, or the degasification from the resist. When the laser spot was used, there was a problem of having less mass productivity as it was difficult to make the size of the seed minute due to the limit of a laser beam diameter or the thermal diffusion, and the laser spot or the underlayer material had to be scanned.

On the other hand, there is known a method for forming a polycrystalline semiconductor thin film on an insulating material such as a quartz substrate, in which the polycrystalline thin film is formed on the insulating material, once made amorphous by implanting ions of the same element as that constituting the thin film, and then crystallized again. For example, when using Si polycrystalline thin film, $Si^{+}$ ions are implanted.

In forming a polycrystalline semiconductor thin film with the above-mentioned conventional method, there was a problem that the crystal grains were difficult to have uniform diameter, and could be only grown up to the size as small as about 1 to 5 $\mu$m, so that the polycrystalline semiconductor thin film having excellent crystallinity could not be obtained.

Also, with the above-mentioned conventional method, there was a problem that the diameter of crystal grains was dispersed, and when fabricating FET (Field Effect Transistor) with this conventional method, it was difficult to fabricate FET having a large mobility with small grain diameters which could not be uniformly obtained, and there was a dispersion in the number of grain boundaries within a channel, depending on the product.

SUMMARY OF THE INVENTION

In view of the above-mentioned problems, it is an object of the present invention to provide a method for forming a seed in a self-aligned manner without the use of a resist or a laser spot, while making the size of the seed minute.

Another object of the present invention is to provide a method for forming a polycrystalline semiconductor film in which the crystal grain diameter can be controlled or made uniform, using a seed obtained with the present invention, and the polycrystalline semiconductor film having larger grain diameters than that conventionally obtained, or crystals having small grain diameters can be uniformly formed.

BRIEF DESCRIPTION OF THE DRAWINGS

Fig. 1A to 1D are schematic views illustrating an embodiment for the method of the present invention.
Fig. 2 is a schematic view for explaining the size of a seed.
Fig. 3 is a graph showing the relation between the dose of ion and the depth of amorphous area.
Fig. 4A to 4C are schematic views illustrating an embodiment for the step.
Fig. 5A to 5D are schematic views illustrating another embodiment for the method of the present invention.
Fig. 6 is a schematic view illustrating an embodiment of an integrated circuit formed using the present invention.

Fig. 7 is a graph showing the relation between the anneal temperature and the sheet resistance of polycrystalline Si when using As as dope ion species.

Fig. 8 is a graph showing the relation between the anneal temperature and the sheet resistance of polycrystalline Si when using P as dope ion species.

Fig. 9A to 9C are schematic views illustrating another embodiment for the method of the present invention.

Fig. 10 is a schematic plan view illustrating a polycrystalline semiconductor film obtained with the method of the present invention in a crystal growth direction.

## DETAILED DESCRIPTION OF THE PREFERRED EMBODIMENTS

The method for forming a seed according to the preferred embodiment of the present invention is as follows.

There is provided a method for forming a seed in which a crystalline film is formed on an underlayer material, and then partly made amorphous by ion implanting impurities into the crystalline film, with a crystalline portion left in part thereof, characterized in that after forming a step on the underlayer material, the crystalline film is formed, and ions are implanted over its entire surface of crystalline film.

The method for forming a semiconductor film according to the preferred embodiment of the present invention is as follows.

There is provided a method for forming a semiconductor film, including a process a for making a polycrystalline thin film amorphous by implanting ions of a heavier element than that constituting the thin film into the polycrystalline thin film formed on the surface of an insulating material, and a process b for crystallizing the amorphous thin film, characterized in that by providing a step on the surface of the insulating material, a part thereof residing at an edge portion within the step is left as a seed in a crystalline state, and the crystalline film is formed by crystallization with the seed.

With the method for forming the seed according to the present invention, a minute seed can be formed in a self-aligned manner, owing to the fact that the film thickness in a crystalline film forming direction is larger in the vicinity of the edge portion of the step than in its peripheral portion. Also, as the resist is not used at the ion implantation, the seed can be formed with less contamination on the film surface. Further, as the laser spot is not used, the productivity can be raised.

On the other hand, with the method for forming the semiconductor film according to the present invention, by providing a step on the substrate on which the polycrystalline thin film for the formation of semiconductor thin film is laminated, a seed crystal can be left behind within the step to be useful in recrystallization after being made amorphous and thereby allow the crystal growth using the seed.

Accordingly, it is possible to control the growth direction of crystal, the direction of grain boundary, the grain diameter, etc. by selecting the shape and disposition of the step, and for example, it is possible to form a crystal having a larger grain diameter than that obtained with the conventional method, or provide a polycrystalline semiconductor film without dispersion of grain diameter.

Further, it is possible to dispose a minute seed crystal at a desired position with the self-alignment, facilitate the conversion into amorphous structure by implanting ions of a heavier element than its own element, and greatly shorten the processing time required in crystallization. In Si, Sn, in addition to Ge, can be used, for example, because it is a diamond type semiconductor.

Also, it is possible to obtain FET having a larger mobility by forming a semiconductor thin film for use as the FET with the method of the present invention.

Further, the method of the present invention allows excellent ion implantation even without using the resist mask in the ion implantation, so that it is possible to avoid the influence of sputtering of the resist mask and the contamination of impurities due to the gas generation.

In the present invention, owing to the provision of a step on the underlayer material, the film thickness in the crystalline film forming direction is larger in the vicinity of the edge portion of the step having the crystalline film formed than in its peripheral portion. When impurities are ion implanted into this crystalline film, a crystalline area which is not amorphous remains by ion implantation of impurities on a part of the crystalline film in the vicinity of the edge portion of the step, and is used as a seed. This is because the reaching distance of impurities by ion implantation is uniform.

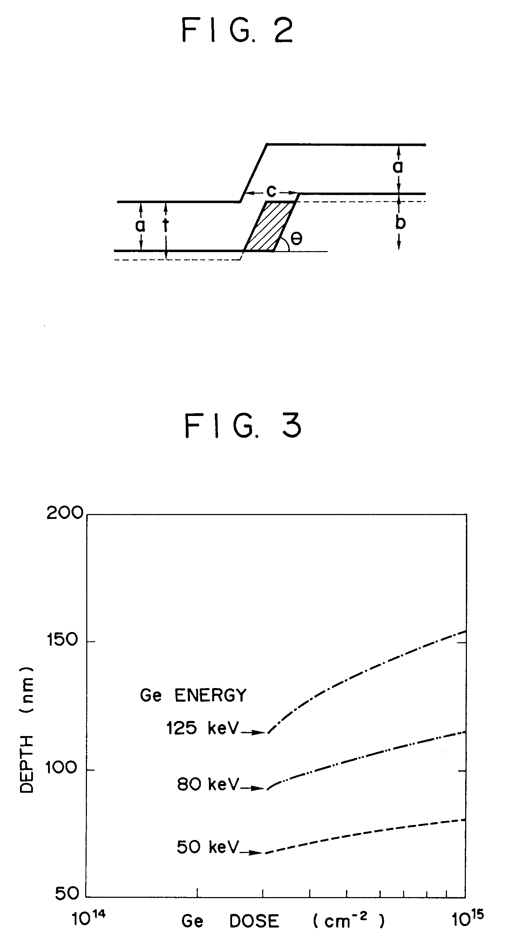

Also, in the present invention, it is possible to freely change the size of the seed by adjusting the shape of the step, the film thickness of crystalline film, and the implantation conditions of impurity ions. The relation between the size of the seed and such conditions will be explained in an ideal case, using a schematic view as shown in Fig. 2.

In Fig. 2, a is a film thickness of crystalline film, b is a height of step, c is a thickness of step in a lateral

3

direction, $\theta$ is an inclination angle of step, and t is a depth of amorphous structure.

From Fig. 2, the condition for forming a seed only in the edge portion can be given by the range of a <t <a + b(when c > b tan$\theta$) or a < t < c tan$\theta$ (when c > b tan$\theta$). The seed region can be given by a parallelogram region having a base of c - t/tan$\theta$, a height of a + b - t, and an angle of $\theta$. Note that as the edge portion actually has a curvature, the seed region is shaped correspondingly.

Further, the depth t of the amorphous area may vary depending on ion species, the dose and the acceleration voltage. Table 1 shows the relation between the ion species and the critical dose for the amorphous formation.

| Ion species Critical dose (cm$^{-2}$) | B$^+$ $2\times10^{16}$ | P$^+$ $1\times10^{15}$ | As$^+$ $3\times10^{14}$ | Sb$^+$ $1\times10^{14}$ |
|---|---|---|---|---|
| (Substrate Si, room temperature) | | | | |

Also, Fig. 3 shows the relation between the dose, the acceleration voltage and the depth of amorphous area, when the ion species is Ge as an example.

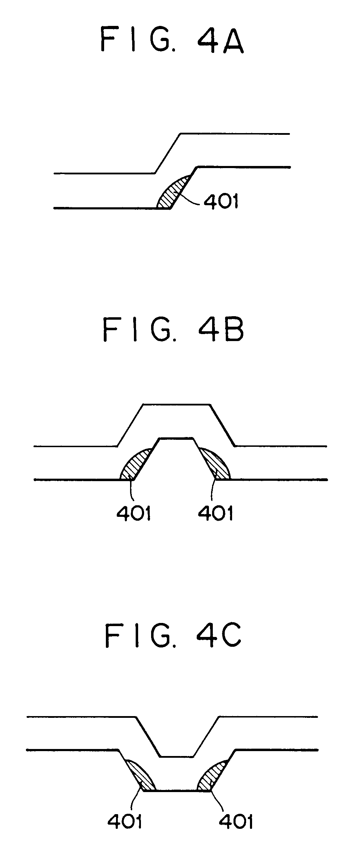

Exemplary of the pattern of the step to be formed are those as shown in Fig. 4, for example, but the present invention is not limited to such patterns.

In Fig. 4, 401 is a seed. In order to form the seed, $\theta$ as indicated in Fig. 2 should be set in a range from 30° to 60°, for example, so that the seed can be efficiently formed.

Examples of the underlayer material include insulating materials such as glass, besides $SiO_2$, $Al_2O_3$ - (sapphire, ruby), BN, $Si_3N_4$, $SiO_2$. Also, examples of the underlayer material include semiconductors such as Si, SiGe, SiCGe, GaAs, InP, InAs, GaP, ZnSe, ZnS, CdS.

Examples of the crystalline film formed on the underlayer material include semiconductor materials such as Si, SiGe, SiC, Ge, GaAs, InP, InAs, GaP, ZnSe, ZnS, CdS. The present invention can be applied without specific limitation of the grain diameter of crystalline film to be formed.

Since the present invention does not use any resist at the ion implantation after forming the crystalline film, the seed can be formed with less contamination on the film surface. Further, as it does not use the laser spot, the productivity can be raised.

In the method for forming the semiconductor film according to the present invention, by providing a step on the plane of an insulating material on which the polycrystalline thin film for the formation of a semiconductor thin film is laminated, a part thereof residing at the edge portion within the step in the thin film is left behind in the crystalline state, without being ion implanted, when making the thin film amorphous by ion implantation, whereby the next crystallization is performed with the remaining crystal as a seed crystal.

Accordingly, the condition for ion implantation is selected depending on the material of polycrystalline thin film, the film thickness, the shape of step, and the disposition. The normal ion implantation condition is such that the polycrystalline thin film on a flat portion of insulating material except for the step can be made amorphous down to an interface with the insulating material.

In the present invention, it is possible to control the grain diameter of the crystal obtained in the semiconductor thin film and its growth direction by selecting the shape or disposition of the step. For example, it is possible to obtain crystals having larger grain diameters than those conventionally obtained, or uniform small grain diameters.

A method according to one embodiment of the present invention will be described with reference to the drawings.

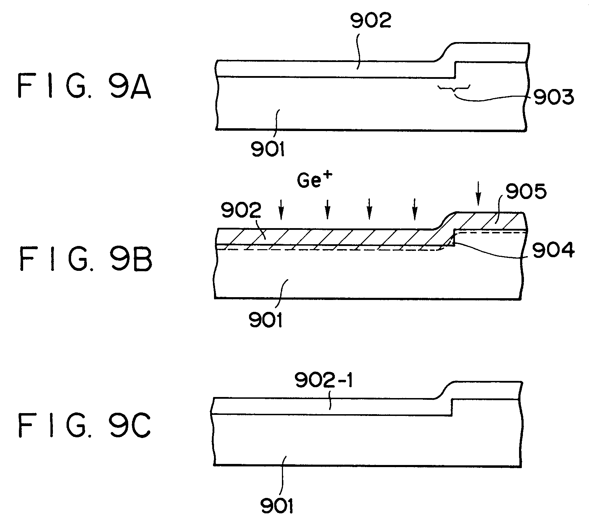

First, a step 903 as shown in Fig. 9A is provided on a substrate 901 made of an insulating material such as a quartz. The shape of this step can be made, for example, with the etching using a resist pattern. Also, the height of the step is selected depending on the film thickness of the polycrystalline thin film, so that the amorphous structure may not extend to a portion 904 at an edge portion within the step for the polycrystalline thin film, in making the thin film amorphous by ion implantation as will be described later, for example.

Then a polycrystalline thin film 902 for the formation of semiconductor thin film as shown in Fig. 9A is laminated on the substrate 901 provided with the step 903. This formation of the thin film 902 can be made with any one of a variety of film forming methods such as a lower pressure chemical vapor deposition (LPCVD) method.

Further, the polycrystalline thin film 902 is made amorphous by ion implantation. For ions implanted into the polycrystalline thin film 902, a heavier element than that constituting the thin film is used. For example, in the Si polycrystalline thin film, Ge$^+$ or Sn$^+$ can be used, and Ge$^+$ is more preferable. The condition for

4

ion implantation is desirably such that a portion of the thin film on the flat portion except for the step as previously described can be made amorphous down to the interface with the substrate 1.

Also, at least a portion of the polycrystalline thin film to be made amorphous is an oxide film, directly oxidized, with which the desired characteristics are to be maintained, the ion density for ion implantation should be greater than the density necessary for making the polycrystalline thin film amorphous, without change of the characteristics of the oxide film obtained by directly oxidizing the polycrystalline thin film.

When $Ge^+$ is ion implanted into the Si polycrystalline thin film, the condition is preferably such as $2.5\times10^{19}$ ions/cm$^3$, and more preferably from $2.5\times10^{19}$ ions/cm$^3$ to $1\times10^{21}$ ions/cm$^3$.

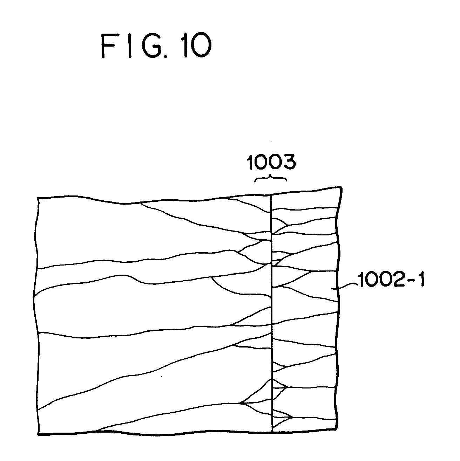

When the thin film is made amorphous down to a portion as indicated by the broken line in Fig. 9B, an amorphous portion 905 is crystallized to obtain a polycrystalline thin film 902-1 as shown in Fig 9C. For the crystallization, the heat treatment can be used. In crystallization, the crystal is grown with a portion of the crystal left behind in the crystalline state rather than in amorphous state at an edge portion 94 within the step 903 as a seed crystal. Fig. 10 schematically shows an example of the crystal grain growth direction in a plan view from above of the substrate. In this example, the crystal grain grows substantially vertically to the step 1003 extending linearly. Accordingly, the size of crystal grain or the growth direction can be controlled by selecting the shape or disposition of the step 1003.

It is considered that the crystal growth as shown in Fig. 10 takes place due to the following reasons.

Since the direction having a higher crystal growth rate is (110), the face having the higher crystal growth rate remains away from the seed, although there are various directions depending on the seed crystal. Mainly, the grain diameters on (100) and (110) faces almost dominate. Also, this phenomenon is considered due to the fact that the thin film is made amorphous by ion implantation down to the interface between the thin film 2 and the substrate 1, thereby yielding less growth nuclei on the interface subjected to the ion damage, and the crystal growth is easily made with the seed embedded into the under portion of the polycrystal.

When the Si polycrystalline thin film is used, the crystal growth can be made more effectively from the seed crystal within the step 3 by implanting $Ge^+$ ions. This is considered due to the fact that since the $Ge^+$ ion is heavier than the $Si^+$ ion, i.e., has a greater mass number, the amorphous structure can be made more efficiently by destroying the Si crystal sufficiently, resulting in no remaining crystal on the flat portion other than the step.

In the above example, the step was first provided on the substrate, but if a variety of functional films are laminated in predetermined patterns on the substrate of an integrated circuit, and the step is already provided, the semiconductor thin film according to the present invention can be formed using that step.

Further, examples of the insulating material constituting the substrate include SiN, AlN, $Al_2O_3$, besides $SiO_2$. In the above example, the polycrystalline thin film was the Si thin film, but a variety of thin films made of Ge, GeAs or mixed crystal Si-Ge can be used, and in the case of GaAs polycrystalline thin film, implanted ions are preferably $In^+$ or $Sb^+$ ions.

In the present invention, the crystallization of the amorphous semiconductor film is performed by annealing, but a lower resistivity of the crystal can be achieved by selecting an appropriate anneal temperature.

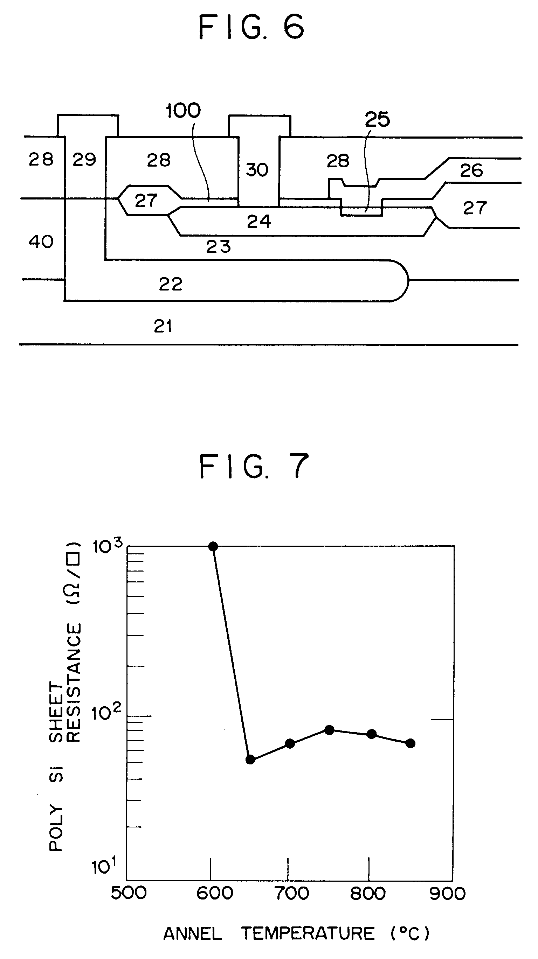

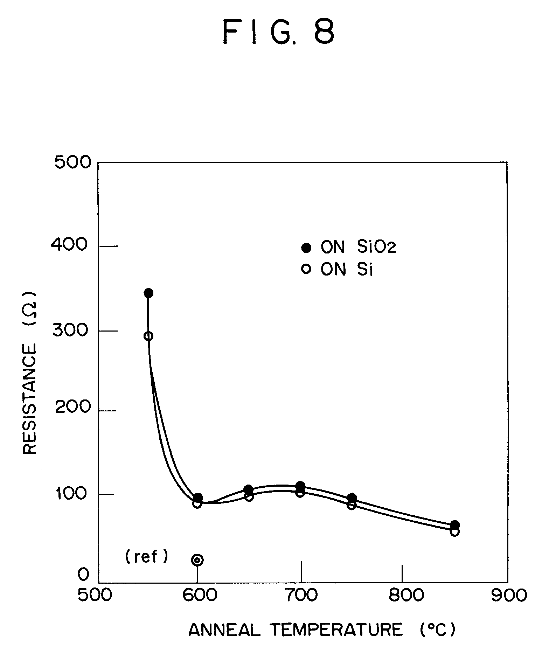

Figs. 7 and 8 show graphs showing the relation between the sheet resistance of poly-Si and the anneal temperature, for the dope ion species of As and P, respectively. As can be clearly seen from Figs. 7 and 8, the resistance becomes lower at 650°C when the dope ion species is As, and it becomes at 600°C when the dope ion species is P. As the process is desired to have a lower temperature, the temperature for the heat treatment to provide a lower resistance of the crystal is preferably from 600 to 700°C.

The present invention will be specifically described by way of examples, but is not limited only to those examples.

Example 1

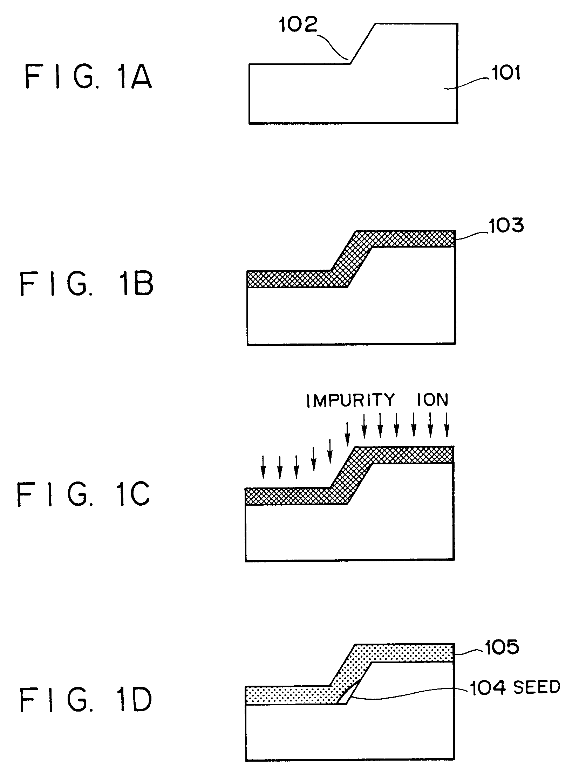

The method for forming a seed in the Si film will be described with reference to Figs. 1A to 1D.

First, as shown in Fig. 1A, a quartz substrate 101 was etched by 4.5% buffered hydrofluoric acid at a temperature of 22°C, at an etching rate of 500 Å/min to form a step 102 having a height of 200 Å. Then as shown in Fig. 1B, a crystalline Si film 103 having a film thickness of 2000 Å was formed on the quartz substrate having this step 102 with a lower pressure chemical vapor deposition (LPCVD) under the following conditions.

$SiH_4$ : 50 sccm
Pressure : 0.3 Torr
Temperature : 620°C

Deposition rate : 100 Å/min

Further, as shown in Fig. 1C, As ions were implanted evenly from above the crystalline Si film, under the conditions of a dose of 5E15 ions/cm$^2$ and an acceleration voltage of 150 keV.

Observing the cross-section of an obtained substrate with a transmission electron microscope, a portion except for the vicinity of the edge portion beneath the step was made amorphous (105 in the figure), but a crystalline area remained as a seed 104 in the vicinity of the edge portion beneath the step, as shown in Fig. 1D. The size of the seed 104 was up to 1000 Å wide and up to 1500 Å high.

Example 2

A step, shaped as shown in Fig. 9, having a height of 2000 Å was provided on a quartz glass substrate by the patterning using a resist, and a polycrystalline Si thin film (with a film thickness of 1700 Å on a flat portion of the substrate) was deposited thereon with the LPCVD method, so that a state as shown in Fig. 9A was obtained. Ge$^+$ ions were implanted into the polycrystalline Si thin film under the conditions of $5 \times 10^{15}$ ions/cm$^2$ and an acceleration voltage of 150 kev, and taking a picture of its cross-section with a transmission electron microscope (TEM), it was confirmed that the polycrystalline layer except for the step portion was made amorphous.

The heat treatment was performed at 650°C for about an hour, so that the polycrystalline semiconductor thin film was obtained. Examining the crystallinity of obtained polycrystalline semiconductor thin film with a transmission electron microscope (TEM), it was confirmed that the crystal was grown substantially vertically to a step direction as shown in Fig. 10, and the grain diameter was as large as about 15 $\mu$m. Further, the size of the crystal was less dispersed.

Comparative example 1

Using a flat quartz substrate without any step, a polycrystalline semiconductor thin film was formed, as in the example 2, by implanting Si$^+$ ions.

As a result, the heat treatment, after making the amorphous structure, was required at about 600°C for over 10 hours to achieve the sufficient crystallization. Further, the grain diameter of the crystal obtained with the crystallization was as small as about 1 to 5 $\mu$m, and the crystal nucleus was random, so that the crystal growth direction and the grain diameter were more dispersed.

Example 3

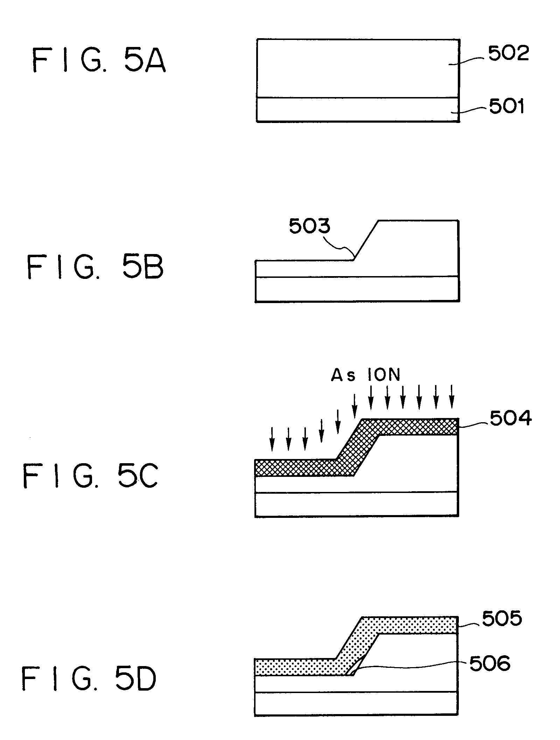

The method for forming a low resistive semiconductor film will be described with reference to Figs. 5A to 5D.

First, as shown in Fig. 5A, SiO$_2$ film 502 was deposited 4000 Å thick as an insulator on Si substrate 501. Then as shown in Fig. 5B, SiO$_2$ film 502 was resist patterned, and then etched by a chemical etching solution containing 4.5% buffered hydrofluoric acid at a temperature of 22°C, at an etching rate of 500 Å/min to form a step 503 having a height of 200Å. Then as shown in Fig. 1C, a polycrystalline Si film 504 having a film thickness of 2000 Å was formed on the SiO$_2$ film 502 having this step 503 with a lower pressure chemical vapor deposition (LPCVD) under the following conditions:

SiH$_4$ : 50 sccm

Pressure : 0.3 Torr

Temperature : 620°C

Deposition rate : 100 Å/min

Further, as shown in Fig. 5D, As ions were implanted over the entire surface of the polycrystalline Si film 504, under the conditions of a dose of 5E15 ions/cm$^2$ and an acceleration voltage of 150 keV, so that a portion 505 except for the vicinity of edge portion of the step was made amorphous, but a polycrystalline area 506 remained in the vicinity of the edge portion. Finally, this sample was annealed at 650°C for an hour.

Observing the plane of the sample thus fabricated with a transmission electron microscope, the solid phase growth was progressed in a lateral direction with the polycrystalline area as a nucleus, and the low resistive Si film having large grain diameter and the grain boundary direction aligned was formed. The sheet resistance of this sample was 55 $\Omega \cdot$cm.

On the contrary, the conditions for ion implantation was changed to the conditions of a dose of 5E15 ions/cm$^2$ and an acceleration voltage of 70 keV, and the surface was made amorphous 1200 Å thick, so that the sheet resistance was 650 $\Omega \cdot$cm, while when amorphous Si was used instead of poly-Si, it was 90 $\Omega \cdot$cm,

it being understood that the sheet resistance formed with the method of the present invention was lower.

Example 4

An integrated circuit as shown in Fig. 6 was fabricated with a normal method. In Fig. 6, 21 is a p-type substrate, 22 is an n$^+$ layer collector, 23 is an n-type layer, 24 is a p-type layer base, and 25 is an n$^+$ layer emitter. 26 is a polycrystalline Si wiring, which was fabricated with the method of the present invention. 27, 28 are $SiO_2$ films, and 29, 30 are Al films, which are a collector electrode and a base electrode, respectively.

A manufacturing process for the semiconductor device as shown in Fig. 6 will be described below.

(1) An n$^+$ embedded region 22 having an impurity density of $10^{15}$ to $10^{19}\,[cm^{-3}]$ is formed by implantation of As, Sb or P ions (or impurity diffusion) into the substrate 21 of a predetermined conductive type (p- or n-type).

(2) An n-type region 23 having an impurity density of $10^{14}$ to $10^{17}\,[cm^{-3}]$ is formed with the epitaxial technique.

(3) An n$^+$ region 40 (with an impurity density of $10^{17}$ to $10^{20}\,[cm^{-3}]$) is formed to decrease the resistance of the collector.

(4) An insulating film 27 for the separation of element is fabricated with selective oxidation method or CVD method.

(5) A p-type region 24 which is a base region is formed in an active region by ion implantation.

(6) An Si polycrystalline layer 26 having a film thickness of 200 Å is deposited with a lower pressure chemical vapor deposition method after opening an emitter contact in the insulating film 100.

(7) As ions of $5E15/cm^2$ are implanted at an acceleration voltage of 150 keV, and the patterning is performed after the annealing at 650°C for one hour in $N_2$ gas.

(8) An insulating film 28 is deposited, and annealed to open a contact.

(9) Al-Si (1%) serving for electrodes 29, 30 are sputtered and then Al-Si is patterend.

(10) Al-Si electrode is made alloy, and formed with a passivation film.

With the above procedure, BPT (bipolar transistor) can be completed.

The integrated circuit thus fabricated is made lower resistive, with an improved speed response.

If this method is applied to the formation of polycrystalline Si wiring or BPT emitter in the integrated circuit, the higher performance can be obtained.

A seed is formed in a manner that a crystalline film is formed on an underlayer material, and then partly made amorphous by ion implanting impurities into the crystalline film, with a crystalline portion left behind in part thereof. After forming a step configuration on the underlayer material, the crystalline film is formed, and ions are implanted over its entire surface of the crystalline film.

**Claims**

1. A method for forming a seed in which a crystalline film is formed on an underlayer material, and then partly made amorphous by ion implanting impurities into said crystalline film, with a crystalline portion left behind in part thereof:
   characterized in that after forming a step on said underlayer material, said crystalline film is formed, and ions are implanted over its entire surface of said crystalline film

2. A method for forming a semiconductor film, including:
   a process a for making a polycrystalline thin film amorphous by implanting ions of a heavier element than that constituting said thin film into said polycrystalline thin film formed on the plane of an insulating material; and
   a process b for crystallizing the amorphous thin film;
   characterized in that by providing a step on said plane of said insulating material, a part of edge portion within said step is left behind as a seed in the crystalline state in said process a, and the crystalline film is formed by making the crystallization with said seed.

3. The method for forming the semiconductor film according to claim 2, wherein the ion density of said heavier element is greater than or equal to a density required for making said polycrystalline thin film amorphous, and not changing the characteristics of an oxide film obtained by directly oxidizing said polycrystalline thin film.

4. The method for forming the semiconductor film according to claim 2, wherein the polycrystalline thin film formed in the process a is a silicone polycrystalline thin film, and ions implanted are germanium ions.

5. The method for forming the semiconductor film according to claim 4, wherein the ion implantation of germanium is performed in a range of $2.5 \times 10^{19}$ ions/cm$^3$ or more.

6. The method for forming the semiconductor film according to claim 4, wherein the ion implantation of germanium is performed in a range from $2.5 \times 10^{19}$ ions/cm$^3$ to $1 \times 10^{21}$ ions/cm$^3$.

7. The method for forming the semiconductor film according to claim 2, wherein said process b is performed with the heat treatment.

8. The method for forming the semiconductor film according to claim 7, wherein said heat treatment is performed in a temperature range from 600°C to 700°C.

FIG. 1A

102

101

FIG. 1B

103

FIG. 1C

IMPURITY ION

FIG. 1D

105

104 SEED

# FIG. 2

# FIG. 3

# F I G. 4A

401

# F I G. 4B

401    401

# F I G. 4C

401    401

F I G. 5A

502

501

F I G. 5B

503

F I G. 5C

As ION

504

F I G. 5D

505

506

# F I G. 6

# F I G. 7

ANNEL  TEMPERATURE  (°C)

# F I G. 8

F I G. 9A

902

903

901

F I G. 9B

Ge⁺

902

905

904

901

F I G. 9C

902-1

901

F I G. 10